# FASCICULE DE BREVET EUROPEEN

(11) **EP 2 750 179 B1**
(45) Date de publication et mention de la délivrance du brevet: **16.06.2021**
(21) Numéro de dépôt: 13198069.0
(22) Date de dépôt: 18.12.2013
(51) Int. Cl.: H01L 21/84, H01L 27/12, H01L 27/118, H03K 19/17736, H01L 29/786

(54) **Circuit intégré comprenant une cellule d'arbre d'horloge**
Integrierter Schaltkreis, der eine Taktbaumzelle umfasst
Integrated circuit including a clock tree cell

(30) Priorité: 26.12.2012 FR 1262811
(43) Date de publication de la demande: 02.07.2014
(73) Titulaire: Commissariat à l'Énergie Atomique et aux Énergies Alternatives, 75015 Paris (FR); STmicroelectronics SA, 92120 Montrouge (FR); STMicroelectronics (Crolles 2) SAS, 38920 Crolles (FR)
(72) Inventeur: Giraud, Bastien, 38000 Grenoble (FR); Abouzeid, Fady, 38000 Grenoble (FR); Clerc, Sylvain, 38000 Grenoble (FR); Noel, Jean-Philippe, 38330 Montbonnot Saint Martin (FR); Thonnart, Yvain, 38100 Grenoble (FR)
(74) Mandataire: INNOV-GROUP

(56) Documents cités:
- WO-A1-2012/160071
- US-A1- 2006 027 877
- JEAN-PHILIPPE NOEL ET AL: "Multi- $V_{T}$ UTBB FDSOI Device Architectures for Low-Power CMOS Circuit", IEEE TRANSACTIONS ON ELECTRON DEVICES, IEEE SERVICE CENTER, PISACATAWAY, NJ, US, vol. 58, no. 8, août 2011 (2011-08), pages 2473-2482, XP011336322, ISSN: 0018-9383, DOI: 10.1109/TED.2011.2155658
- Philippe Flatresse ET AL: "Planar fully depleted silicon technology to design competitive SOC at 28nm and beyond", , février 2012 (2012-02), XP055065624, Extrait de l'Internet: URL:http://www.soiconsortium.org/pdf/fully depletedsoi/planar_fd_silicon_technology_c ompetitive_soc_28nm.pdf [extrait le 2013-06-06]
- J-P NOEL ET AL: "UT2B-FDSOI device architecture dedicated to low power design techniques", SOLID-STATE DEVICE RESEARCH CONFERENCE (ESSDERC), 2010 PROCEEDINGS OF THE EUROPEAN, IEEE, PISCATAWAY, NJ, USA, 14 septembre 2010 (2010-09-14), pages 210-213, XP031787588, ISBN: 978-1-4244-6658-0
- VASILIS F PAVLIDIS ET AL: "Clock distribution networks for 3-D ictegrated Circuits", CUSTOM INTEGRATED CIRCUITS CONFERENCE, 2008. CICC 2008. IEEE, IEEE, PISCATAWAY, NJ, USA, 21 septembre 2008 (2008-09-21), pages 651-654, XP031361544, ISBN: 978-1-4244-2018-6
- None

## Description

L'invention concerne un circuit intégré, et en particulier un circuit intégré réalisé sur un substrat de type silicium-sur-isolant (dit SOI, pour « Silicon On Insulator » en langue anglaise). L'invention concerne également un procédé d'utilisation de ce circuit intégré.

La technologie SOI consiste à séparer une fine couche de silicium (quelques nanomètres) sur un substrat en silicium par une couche d'isolant relativement épaisse (quelques dizaines de nanomètres en règle générale).

Les circuits intégrés réalisés en technologie SOI présentent un certain nombre d'avantages. De tels circuits présentent généralement une plus faible consommation électrique pour des performances équivalentes, ou une même consommation pour de meilleurs performances. De tels circuits induisent également des capacités parasites plus faibles, qui permettent d'améliorer la vitesse de commutation. De plus, le phénomène de déclenchement parasite (« latchup » en langue anglaise) rencontré par les transistors métal-oxyde-semi-conducteur (MOS) en technologie « bulk » peut être évité. De tels circuits s'avèrent donc particulièrement adaptés pour des applications de type SoC (« Systems on Chip » en langue anglaise) ou MEMS (« Micro Electro-Mechanical Systems » en langue anglaise). On constate également que les circuits intégrés SOI sont moins sensibles aux effets des radiations ionisantes et s'avèrent ainsi plus fiables dans des applications où de telles radiations peuvent induire des problèmes de fonctionnement, notamment dans des applications spatiales. Les circuits intégrés SOI peuvent notamment comprendre des mémoires vives de type SRAM (« Static Random Access Memory » en langue anglaise) ou des portes logiques.

La réduction de la consommation statique de portes logiques tout en augmentant leur vitesse de basculement fait l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on abaisse la tension de seuil (« threshold voltage » en langue anglaise, et en abrégé VT) de certains transistors pour former des portes logiques à vitesse de basculement élevée, et on augmente la tension seuil d'autres transistors pour former des portes logiques à faible consommation. En technologie « bulk », la modulation du niveau de tension de seuil de transistors de même type est principalement effectuée en différenciant le niveau de dopage de leur canal. Cependant, en technologie semi-conducteur sur isolant à canal complètement déserté, plus connue sous l'acronyme FDSOI (pour « Fully Depleted Silicon On Insulator » en langue anglaise), le dopage du canal est quasiment nul (10¹⁵ cm⁻³). Ainsi, le niveau de dopage du canal des transistors ne peut donc pas présenter de variations importantes, ce qui empêche de différencier les tensions de seuil par ce biais. Une solution proposée dans certaines études, pour réaliser des transistors de même type à tensions de seuil distinctes, est d'intégrer différents matériaux de grille pour ces transistors. Cependant, la réalisation pratique d'un tel circuit intégré s'avère techniquement délicate et économiquement prohibitive.

Afin de disposer de tensions de seuil distinctes pour différents transistors en technologie FDSOI, il est également connu d'utiliser un plan de masse (« ground plane » ou « back-plane » en langue anglaise) électriquement polarisé disposé entre une couche d'oxyde isolante mince et le substrat de silicium. En jouant sur le type de dopage des plans de masse et sur leur polarisation électrique, il est possible d'améliorer le contrôle électrostatique de ces transistors, ce qui permet de définir différentes gammes de tensions de seuil pour ces transistors. On peut ainsi disposer de transistors à faible tension de seuil, dits LVT (pour « Low V_{T} » en langue anglaise), de transistors à haute tension de seuil, dits HVT (pour « High V_{T} » en langue anglaise), et de transistors à tension de seuil intermédiaire, dits SVT (pour « Standard VT » en langue anglaise), ou RVT (pour « Regular VT » en langue anglaise). Typiquement, les transistors LVT présentent une tension de seuil inférieure ou égale à 350mV, les transistors HVT supérieure ou égale à 500mV et les transistors RVT comprise entre 350mV et 500mV.

De tels transistors sont décrits, par exemple, dans la note d'application technique de P. Flatresse et al., « Planar fully depleted silicon technology to design competitive SOC at 28nm and beyond », STMicroelectronics, 2012.

De l'état de la technique pertiment est également connu des documents suivants :
- WO 2012/160071 A1 (CEA);
- Jean-Philippe Noel et al. « Multi-VT UTBB FDSOI device architectures for low-power CMOS circuit », IEEE Transactions on Electron Devices, vol. 58, p. 2473-2482, août 2011 ;
- US 2006/027877 A1 (INABA).
WO 2012/160071 est considéré comme représentant l'état de la technique le plus proche par rapport auquel le préambule de la revendication 1 est délimité.

De façon connue, les circuits intégrés logiques synchrones nécessitent un signal d'horloge pour synchroniser le fonctionnement d'éléments logiques du circuit. Typiquement, ce signal d'horloge est distribué depuis un générateur de signal d'horloge vers des éléments du circuit, tels que des registres ou des bascules, par l'intermédiaire d'un arbre d'horloge (« clock tree » en langue anglaise). Cet arbre d'horloge est un réseau d'interconnexions électriques qui présente typiquement une structure arborescente, comportant un tronc commun, relié au générateur de signal d'horloge et se partageant en une multitude de rameaux, ou branches. Chacune de ces branches peut elle-même se partager en une pluralité de branches additionnelles.

Pour assurer un bon fonctionnement du circuit, et notamment éviter des erreurs de minutage (« setup & hold time violations » en langue anglaise), cet arbre d'horloge doit être soigneusement configuré pour limiter l'apparition de différences de temps de propagation (« clock skew » en langue anglaise) du signal d'horloge. A cet effet, l'arbre d'horloge comprend typiquement des cellules d'arbre d'horloge, qui implémentent des fonctions optimisant la distribution du signal d'horloge, telles que l'ajout de délais (« buffer » en langue anglaise). Ainsi, chaque cellule d'arbre d'horloge est reliée à une branche de l'arbre d'horloge, et reçoit de cet arbre d'horloge un signal d'horloge entrant. Cette cellule d'arbre d'horloge est également adaptée pour fournir un signal d'horloge sortant, apte à être distribué aux éléments logiques du circuit. Dans le cas où la cellule d'arbre d'horloge présente un délai, le signal d'horloge sortant est identique au signal d'horloge entrant, sauf qu'il présente un retard égal à une valeur prédéfinie. Ces délais peuvent être adaptés lors d'étapes de conception du circuit intégré, pour équilibrer les branches de l'arbre d'horloge et contrôler l'apparition de différences de temps de propagation.

Cependant, l'intégration d'une telle cellule d'arbre d'horloge au sein d'un circuit comprenant des cellules standards de technologie FDSOI de tensions de seuil différentes présente de nombreux inconvénients. En particulier, la cellule d'arbre d'horloge doit, au sein de chaque bloc, être suffisamment isolée des cellules standards pour éviter que son fonctionnement ne soit affecté par des polarisations électriques appliquées au plan de masse de ces cellules standards. On connaît, pour le nœud technologique 28nm, des cellules d'arbre d'horloge aptes à être intégrées dans un tel bloc, mais qui imposent une augmentation de la superficie occupée par rapport à une cellule standard. Une telle augmentation de superficie peut être rédhibitoire au vu des exigences de miniaturisation des circuits intégrés, notamment, pour le nœud technologique 20nm. En outre, de telles cellules d'arbre d'horloge sont difficiles à intégrer au sein d'un même bloc avec des cellules standard présentant des transistors de tension de seuil différentes.

Il existe donc un intérêt pour un circuit intégré comprenant des transistors de technologie FDSOI, ce circuit intégré comprenant une cellule d'arbre d'horloge qui soit électriquement isolée des cellules standard du circuit, tout en minimisant la superficie requise pour intégrer cette cellule d'arbre d'horloge au sein d'un bloc de cellules standard comprenant des transistors de tensions de seuil différentes.

L'invention concerne ainsi un circuit intégré conforme à la revendication 1.

Ici, par « polarisation appliquée directement sur un plan de masse » on désigne notamment le fait que la tension de polarisation du plan de masse est appliquée directement sur ce plan de masse sans passer par l'intermédiaire d'un caisson. En choisissant, pour la cellule d'arbre d'horloge, un plan de masse avec un dopage de type opposé au dopage du caisson, ce plan de masse forme avec le caisson une jonction p-n qui permet d'isoler électriquement la cellule d'arbre d'horloge des cellules standard adjacentes partageant ce même caisson. Ainsi, la polarisation électrique de ce plan de masse peut être électriquement isolée de la polarisation des plans de masse des transistors appartenant aux cellules standard contiguës à cette cellule d'arbre d'horloge.

Les modes de réalisation de l'invention peuvent comporter une ou plusieurs des caractéristiques des revendications 2 à 11.

Ces modes de réalisation présentent en outre les avantages suivants :
- les prises de polarisation des plans de masse permettent d'appliquer une tension électrique directement sur ces plans de masse, sans avoir à appliquer cette polarisation par l'intermédiaire des caissons.
- en choisissant, pour chaque plan de masse de la cellule d'arbre d'horloge, des dopages de type opposés aux caissons qui sont en contact électrique avec ces plans de masse, la cellule d'arbre d'horloge présente une isolation électrique renforcée, ce qui assure de meilleures performances de l'arbre d'horloge.
- en choisissant des dopages des plans de masse de la cellule d'arbre d'horloge de façon à ce qu'un de ces plans de masse présente un dopage de type opposé au dopage du caisson qui est en contact électrique avec ce plan de masse, et qu'un autre de ces plans de masse présente un dopage de même type que le caisson qui est en contact électrique avec ce plan de masse, la cellule d'arbre d'horloge présente une isolation électrique dite partielle. Cela permet de faciliter l'intégration de cette cellule d'arbre d'horloge dans un bloc comprenant des cellules standard comprenant des tensions de seuil distinctes.
- le caisson unique permet de placer plus facilement côte à côte des cellules standard présentant des tensions de seuil de type différent.

L'invention concerne également un procédé d'utilisation d'un circuit intégré conforme à la revendication 12.

L'invention sera mieux comprise à la lecture de la description qui va suivre, donnée uniquement à titre d'exemple non limitatif et faite en se référant aux dessins sur lesquels :
- la figure 1 est une illustration schématique d'une partie d'un circuit intégré comprenant un arbre d'horloge ;
- la figure 2 est une illustration schématique d'une coupe longitudinale d'un bloc du circuit intégré de la figure 1 ;
- la figure 3 est une vue schématique en coupe transversale d'une cellule standard du bloc de la figure 1 ;
- la figure 4 est une vue schématique en coupe d'une cellule d'arbre d'horloge du bloc de la figure 2 ;
- la figure 5 est un organigramme d'un procédé d'utilisation du circuit de la figure 1
- la figure 6 est une illustration schématique d'une coupe longitudinale d'un autre mode de réalisation d'une rangée du bloc de la figure 2 ;
- la figure 7 est une vue schématique en coupe d'un autre mode de réalisation de la cellule de la figure 3 ;
- la figure 8 est une vue schématique en coupe d'un autre mode de réalisation de la cellule de la figure 4 ;
- la figure 9 est une vue schématique en coupe d'un autre mode de réalisation de la cellule de la figure 4 ou 8 ;
- la figure 10 est une vue schématique en coupe longitudinale d'un autre mode de réalisation de la rangée de la figure 6 ;
- la figure 11 est une vue schématique en coupe d'un autre mode de réalisation de la cellule de la figure 4 ou 8.

Dans ces figures, les mêmes références sont utilisées pour désigner les mêmes éléments.

Dans la suite de cette description, les caractéristiques et fonctions bien connues de l'homme du métier ne sont pas décrites en détails.

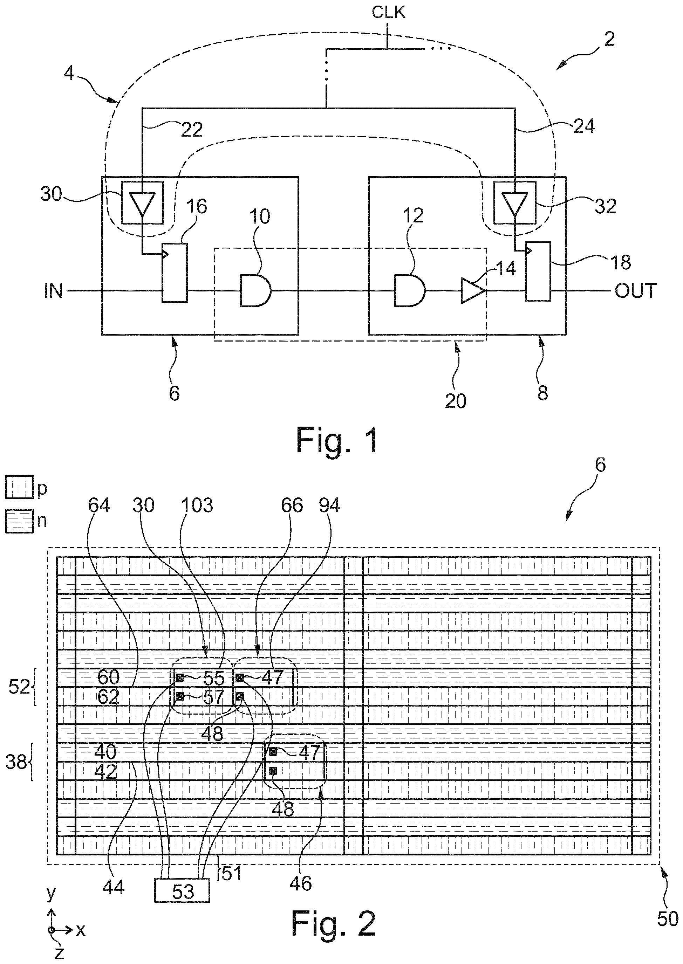

La figure 1 représente, de manière simplifiée, une partie d'un circuit intégré 2, contenant un arbre d'horloge 4. Dans cet exemple, le circuit 2 comprend des blocs 6 et 8 qui contiennent une pluralité d'éléments logiques (tels que des portes logiques) et d'éléments synchrones (tels que des bascules), formés à partir de transistors contenus dans des cellules standards disposées dans ces blocs 6 et 8. Pour simplifier, seuls trois éléments logiques 10, 12 et 14 sont représentés. De même, seuls deux éléments synchrones 16 et 18 sont représentés. Les éléments 10, 12 et 14 sont connectés entre eux de manière à former un ensemble 20, configuré pour accomplir une fonction logique prédéfinie. Cet ensemble 20 est configuré pour recevoir un signal d'entrée IN et pour fournir un signal de sortie OUT en réponse au signal IN. L'arbre d'horloge 4 est apte à transmettre un signal d'horloge CLK aux éléments 16 et 18 du circuit 2, de telle sorte que ce signal CLK soit reçu, de préférence simultanément, par ces éléments 16 et 18, pour synchroniser le fonctionnement de l'ensemble 20 avec le reste du circuit 2. Dans cet exemple, le signal CLK est un signal périodique présentant une forme en créneaux.

Cet arbre d'horloge 4 est un réseau d'interconnexions électriques, présentant ici une forme en arborescence comprenant une pluralité de branches. Pour simplifier, seules deux branches 22 et 24 de cet arbre 4 sont représentées. Dans cet exemple, la branche 22 est reliée à une entrée d'horloge de l'élément 16, et la branche 24 est reliée à une entrée d'horloge de l'élément 18. Afin de limiter des différences de temps de propagation du signal CLK dans les branches 22 et 24 l'arbre 4 comprend une pluralité de cellules d'arbre d'horloge. Chacune de ces cellules d'horloge est ici configurée pour retarder la propagation du signal CLK avec un retard prédéfini, de préférence identique. Ainsi, l'ajout sélectif de cellules d'arbre d'horloge dans des branches de l'arbre 4 permet de réduire ces différences de temps de propagation. Dans cet exemple, seules deux cellules d'arbre d'horloge 30, 32 sont représentées. Par exemple, ces cellules 30 et 32 sont des feuilles de l'arbre 4. Ces cellules 30 et 32 sont ici insérées, respectivement, au sein de chacun des blocs 6 et 8. Ces cellules 30 et 32 sont ici structurellement identiques, sauf que la cellule 30 est réalisée à l'intérieur du bloc 6 et que la cellule 32 est réalisée à l'intérieur du bloc 8.

La figure 2 représente plus en détail le bloc 6 du circuit intégré 2. Ce circuit 2 comprend :
- un substrat semi-conducteur 50,
- une pluralité de rangées de cellules, et
- la cellule arbre d'horloge 30.

Le substrat 50 s'étend essentiellement dans un plan dit « plan du substrat ». Ici, le plan du substrat est parallèle à des directions horizontales orthogonales X et Y. Ce plan du substrat est perpendiculaire à une direction verticale Z. Ce plan du substrat forme une partie inférieure du circuit 2. Ce substrat 50 présente ici un dopage de type p avec une concentration de dopants inférieure ou égale à 10¹⁶ cm⁻³ ou à 3*10¹⁵ cm⁻³. Pour simplifier la figure 2, le substrat 50 est représenté sous la forme de traits pointillés. Ce substrat 50 est ici relié électriquement à une masse électrique GND du circuit 2.

Les rangées présentent ici une forme sensiblement rectiligne et s'étendent, au sein du bloc 6, toutes suivant la direction X. Ces rangées présentent une même hauteur, mesurée selon la direction Y. Ces rangées sont disposées parallèlement les unes aux autres et sont contiguës deux à deux le long d'un de leurs côtés parallèle à la direction X.

Chaque rangée comprend ici :
- deux caissons (« well » en langue anglaise) semi-conducteurs présentant des dopages de types opposés ;
- des cellules standard, placées les unes à côté des autres le long de cette rangée.

Dans cet exemple, les rangées du bloc 6 sont placées dans une configuration dite retournée (« flipped rows » en langue anglaise) : les positions des caissons sont permutées d'une rangée sur l'autre, dans la direction Y, de telle sorte que deux caissons contigus l'un à l'autre et appartenant respectivement à deux rangées contiguës l'une de l'autre présentent un même dopage.

Pour simplifier, seule une rangée 38 est décrite en détail. Les autres rangées sont sensiblement identiques, sauf que les caissons présentant des types de dopages opposés sont permutés en alternance d'une rangée sur l'autre.

Cette rangée 38 comprend :
- deux caissons semi-conducteurs 40 et 42, présentant des dopages de type opposé et séparés entre eux par une tranchée d'isolation profonde 44 (« trench isolation » en langue anglaise) ;
- une pluralité de cellules standard, placées les unes à côté des autres dans la rangée 38.

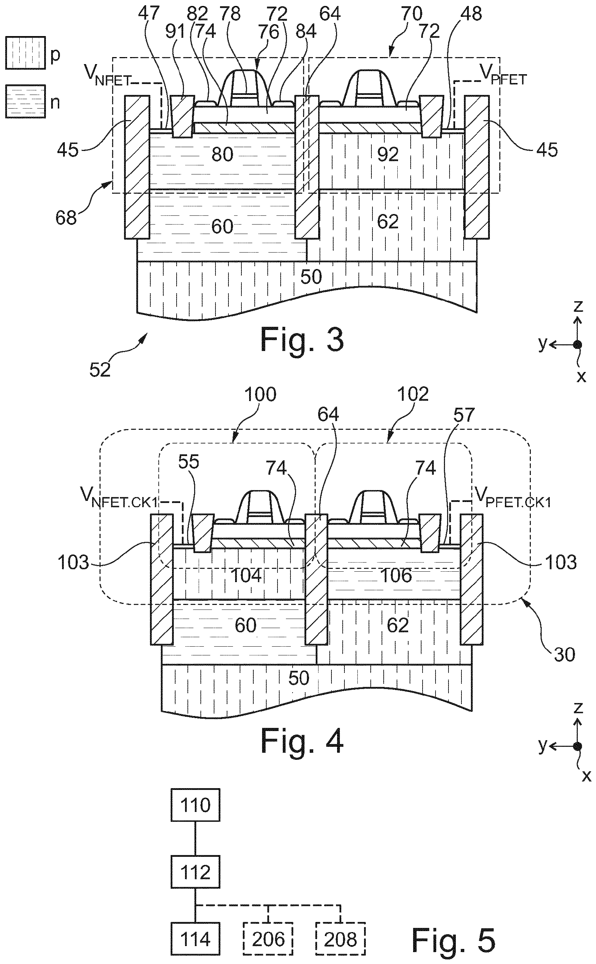

Ces cellules standard sont placées les unes à côté des autres le long de la direction X. Ces cellules standard présentent ici chacune une forme sensiblement rectangulaire, avec une même hauteur que les rangées. Pour simplifier, une seule cellule standard 46 est représentée dans cette rangée 38. Ces cellules standard sont séparées les unes des autres par des tranchées d'isolation 45. Sur le côté où des cellules 46 se touchent, la tranchée 45 est commune à ces cellules. Cette cellule 46 comporte des prises de polarisation 47 et 48, qui seront décrites plus en détail en référence à la figure 3.

Les caissons 40 et 42 sont disposés l'un à côté de l'autre dans un même plan, appelé « plan des caissons », parallèle au plan du substrat. Ces caissons 40 et 42 s'étendent chacun dans ce plan des caissons, parallèlement à la direction X. Ces caissons 40 et 42 sont ici situés au-dessus du substrat 50.

Dans cet exemple, le caisson 40 présente un dopage de type n. Le caisson 42 présente un dopage de type p. Les caissons 40 et 42 présentent une concentration de dopants comprise entre 10¹⁶ et 10¹⁹ cm⁻³.

La tranchée 44 s'étend parallèlement à la direction X, contiguëment aux caissons 40 et 42 et sur toute la longueur de ces caissons. La tranchée 44 est décrite plus en détail en référence à la figure 3, sous la référence 64.

Avantageusement, le circuit 2 comporte :
- un réseau d'alimentation électrique 51, et
- une source d'alimentation électrique 53, apte à délivrer des tensions électriques sur le réseau 51.

Le bloc 6 comporte également une rangée 52. La rangée 52 est, par exemple, identique à la rangée 38, sauf qu'elle comporte, en plus des cellules standard, la cellule 30. Sur la figure 2, dans la rangée 52 :
- les caissons correspondant aux caissons 40 et 42 portent, respectivement, les références 60 et 62 ;
- la tranchée correspondant à la tranchée 44 porte la référence 64, et
- les cellules standard portent la référence 66. Pour simplifier, seule une cellule standard 66, contiguë à la cellule 30, est représentée.

Ici, des cellules sont dites « contiguës », si elles sont uniquement séparées l'une de l'autre par une tranchée d'isolation, typiquement, profonde.

Tout ce qui a été décrit en référence à la rangée 38 s'applique à la rangée 52.

La cellule 30 (figure 2) est apte à recevoir un signal d'horloge entrant, et à transmettre un signal d'horloge sortant à une cellule 66 du bloc 6. Ici, le signal entrant est le signal d'horloge CLK. Cette cellule 30 est contiguë à des cellules standard. Par exemple, la cellule 30 est placée dans la rangée 52, contiguëment à la cellule 66, de manière à ce que les caissons 60 et 62 s'étendent sous la cellule 30. La cellule 30 comporte en outre des prises de contact 55 et 57, identiques, respectivement, aux prises 47 et 48.

La figure 3 représente plus en détail la cellule 66. Typiquement, chaque cellule comprend ici deux transistors, le drain d'un de ces transistors étant directement connecté électriquement à la source de l'autre transistor de la même cellule. Dans la suite de cette description, pour simplifier les figures, cette connexion électrique entre les deux transistors d'une même cellule n'a pas été représentée. La cellule 66 comprend des transistors 68 et 70 à effet de champ de type métal oxyde semi-conducteur (MOS), disposés l'un à côté de l'autre dans la direction Y. Ces transistors 68 et 70 sont réalisés suivant la technologie dite de silicium sur isolant à canal complètement déserté. Les transistors 68 et 70 sont placés, respectivement, à l'aplomb des caissons 60 et 62.

Le transistor 68 comprend ainsi :
- une couche 72 semi-conductrice, dite couche active ;
- une couche enterrée 74 de matériau électriquement isolant, situé sous la couche 72 ;
- un empilement de grille 76, situé sur la couche 72 et comportant notamment une grille 78 ;
- un plan de masse semi-conducteur 80, situé sous la couche 74 et immédiatement sur le caisson 60, de manière à être en contact électrique direct avec ce caisson 60.

La couche 72 forme un canal entre une source 82 et un drain 84. De façon connue en technologie FDSOI, cette couche 72 est dans un état totalement déserté (« depleted » en langue anglaise) et présente un niveau de dopage très faible, typiquement inférieur ou égal à 10¹⁵ cm⁻³. Cette couche 72 présente une épaisseur inférieure ou égale à 10 nm et, de préférence, inférieure ou égale à 8 nm.

Dans cette description, l'épaisseur et la profondeur sont définies par rapport à la direction Z. La profondeur est définie par rapport à un plan de référence horizontal, passant, par exemple, par la couche 74.

La couche 74 isole électriquement la couche 72 du plan de masse 80. Cette couche 74 s'étend sensiblement parallèlement au plan du substrat. La couche 74 est ici de type ultra-fine, selon la technologie connue sous l'acronyme UTBOX (pour « Ultra-Thin Buried Oxide Layer » en langue anglaise), et présente une épaisseur inférieure à 40nm et, de préférence, inférieure ou égale à 25nm. Cette couche 74 est réalisée dans un matériau électriquement isolant. Par matériau électriquement isolant, on désigne ici un matériau dont la résistivité électrique, à une température de 20°C, est supérieure ou égale à 10⁵ Ω.m ou à 10⁶ Ω.m. Cette couche 74 est ici réalisée en oxyde de silicium (SiO₂).

Le plan de masse 80 permet de contrôler des propriétés électrostatiques du transistor 68, en appliquant un potentiel électrique sur ce plan de masse 80 via la prise 47. Cette prise 47 est apte à polariser électriquement le plan de masse 80, lorsqu'une polarisation électrique est appliquée sur cette prise 47 par une source de tension. A cet effet, la prise 47 est en contact électrique direct avec le plan de masse 80. Cette prise 47 comprend, par exemple, une tranchée, ménagée jusqu'au plan de masse 80 et contenant un matériau électriquement conducteur, tel qu'un métal.

Dans cette description, deux éléments sont dits être en contact direct s'ils sont immédiatement en contact physique l'un avec l'autre et si aucun autre élément de nature différente n'est interposé entre ces deux éléments.

La prise 47 est séparée et isolée électriquement de la couche 72 par une tranchée d'isolation courte 91 (« shallow trench insulation » en langue anglaise). La tranchée 91 s'étend, selon la direction Z, depuis la surface supérieure de la couche 72 jusqu'à une profondeur par exemple supérieure ou égale à 20 ou à 30 nm sous la couche 74. Cette profondeur est inférieure à la profondeur de la tranchée 64. Cette tranchée 91 est réalisée dans un matériau électriquement isolant, tel que de l'oxyde de silicium.

Dans cet exemple, le plan de masse 80 présente un dopage de même type que le dopage du caisson 60. La concentration de dopants du plan de masse 80 est ici comprise entre 10¹⁸ et 10²⁰ cm⁻³. Ce plan de masse 80 présente une épaisseur comprise entre 50nm et 300nm et, de préférence, entre 70nm et 200nm. Le plan de masse 80 et le caisson 60 sont ici fabriqués à partir d'un même matériau semi-conducteur, lors d'étapes distinctes d'implantation ionique. Chacun du plan de masse 80 et du caisson 60 présente ici un profil de dopage distinct.

Dans cet exemple, le transistor 68 est un transistor de type n (nMOS). La source 82 et le drain 84 sont réalisés au-dessus de la couche 72. Ce transistor 68 présente ici une tension de seuil de type faible, dite LVT (pour « Low VT » en langue anglaise).

Le transistor 70 est similaire au transistor 68, sauf que :
- le transistor 70 est de type p (pMOS) ;
- le plan de masse 80 est remplacé par un plan de masse semi-conducteur 92, situé uniquement au-dessus et à l'aplomb du caisson 62 et présentant un dopage de même type que le dopage de ce caisson 62 ;
- la prise de contact 47 est remplacée par une prise 48 identique à la prise 47 sauf qu'elle est en contact électrique direct avec le plan de masse 92.

Par exemple, à l'exception des différences ci-dessus, tout ce qui a été décrit en référence au transistor 68 s'applique au transistor 70.

La cellule 66 comprend, en plus de la tranchée 64, la tranchée 45, pour isoler électriquement les transistors de cette cellule 66 des transistors des autres cellules contiguës. L'isolation des transistors signifie notamment que les plans de masse de ces transistors sont isolés électriquement l'un de l'autre. Plus spécifiquement, la tranchée 45 permet d'isoler électriquement les transistors 68, 70 des cellules standard adjacentes à la cellule 66. A cet effet, la tranchée 45 entoure, dans un plan horizontal, la cellule 66 sur tout son pourtour extérieur.

La tranchée 64 permet d'isoler électriquement entre eux les transistors 68 et 70 d'une même cellule 66. Dans cet exemple, la tranchée 64 est située entre les transistors 68 et 70.

Ces tranchées 64 et 45 s'étendent chacune, selon la direction Z, depuis la surface supérieure de la couche 72 jusqu'à une extrémité inférieure, située à l'intérieur du plan des caissons et présentant ici une même profondeur. Ces tranchées 64 et 45 sont, par exemple, réalisées dans un même matériau que la tranchée 91.

La figure 4 représente plus en détail la cellule 30. Cette cellule 30 est identique à la cellule 66, sauf que :
- les transistors 68 et 70 sont remplacés, respectivement, par des transistors 100 et 102 ;
- la tranchée 45 porte la référence 103.

Ces transistors 100, 102 sont eux-mêmes identiques aux transistors 68 et 70, sauf que les plans de masse 80 et 92 sont remplacés par des plans de masse semi-conducteurs 104 et 106.

Par exemple, les plans de masse 104 et 106 sont fabriqués sur les caissons 60 et 62, de la même manière que les plans de masse 80 et 92.

Ici, la tranchée 103 de la cellule 30 est commune avec la tranchée 45 de la cellule 66 immédiatement adjacente à la cellule 30.

Le dopage des plans de masse 104 et 106 est opposé à celui des caissons 60 et 62, et donc à celui des plans de masse 80 et 92 de la cellule 66. Les polarisations appliquées sur ces plans de masse sont choisies de telle sorte à permettre d'éviter des courants de fuite résultant de la formation de jonctions p-n polarisées en sens direct entre les plans de masse 104, 106 et 80, 92, via les caissons 60 et 62. Ainsi, les polarisations électriques des plans de masse 104 et 106 ne sont pas perturbées électriquement par des polarisations électriques appliquées sur les plans de masse 80 et 92.

Le réseau 51 est apte à appliquer des polarisations électriques distinctes sur les plans de masse 80 et 92, 104 et 106. Pour cela, ce réseau 51 est ici relié électriquement aux prises 47, 48, 55 et 57 par des liaisons électriquement isolées les unes des autres.

Cette polarisation des plans de masse 104 et 106 permet de contrôler des propriétés électrostatiques des transistors 100 et 102. Ce contrôle permet notamment de compenser dynamiquement une asymétrie entre des propriétés électriques des transistors 100 et 102.

En effet, les transistors 100 et 102 de la cellule 30 forment ici un élément logique de type CMOS (« Complementary Metal Oxide Semiconductor » en langue anglaise). Les transistors 100 et 102 présentent un rapport de symétrie (« beta ratio » en langue anglaise) choisi ici de façon à ce que les temps de montée et de descente (« rise time » et « fall time » en langue anglaise) du signal d'horloge sortant transmis par cette cellule 30 soient sensiblement égaux.

Une modification de ce rapport de symétrie, dite asymétrie, entre des transistors d'une même cellule d'arbre d'horloge peut affecter défavorablement le comportement de l'arbre 4. Cette asymétrie peut dépendre de paramètres non contrôlables et/ou non prévisibles, tels que de l'environnement de fonctionnement du circuit 2 (par exemple la température), ou des variabilités aléatoires dans le processus de fabrication du circuit 2.

En outre, la cellule 30 étant sensiblement identique à la cellule 66, elle présente des mêmes dimensions que cette cellule 66. Ainsi, la cellule 30 occupe sur le circuit 2 la même superficie qu'une cellule standard.

Un exemple du fonctionnement du circuit 2 va maintenant être décrit, en référence au procédé de la figure 5.

Lors d'une étape 110, le circuit 2 est fourni. Ce circuit est, par exemple, mis en marche et alimenté par une source de tension électrique.

Puis, lors d'une étape 112, des polarisations électriques V_{PFET} et V_{NFET} sont appliquées, respectivement, sur les plans de masse 92 et 80.

Lors d'une étape 114, des polarisations électriques V_{PFET_CK1} et V_{NFET_CK1} sont appliquées en même temps que les polarisations V_{PFET} et V_{NFET}, respectivement, sur les plans de masse 106 et 104.

Ces polarisations V_{PFET} et V_{NFET}, V_{PFET_CK1} et V_{NFET_CK1} sont ici appliquées par le réseau 51. Les polarisations V_{PFET_CK1} et V_{NFET_CK1} sont, respectivement, supérieure ou égale à V_{PFET} et inférieure ou égale à V_{NFET}, pour polariser en inverse les jonctions p-n formées, respectivement, entre le plan de masse 104 et le caisson 60, et le plan de masse 106 et le caisson 62. Ces polarisations V_{PFET} et V_{NFET} sont ici toutes deux égales à la masse GND du circuit.

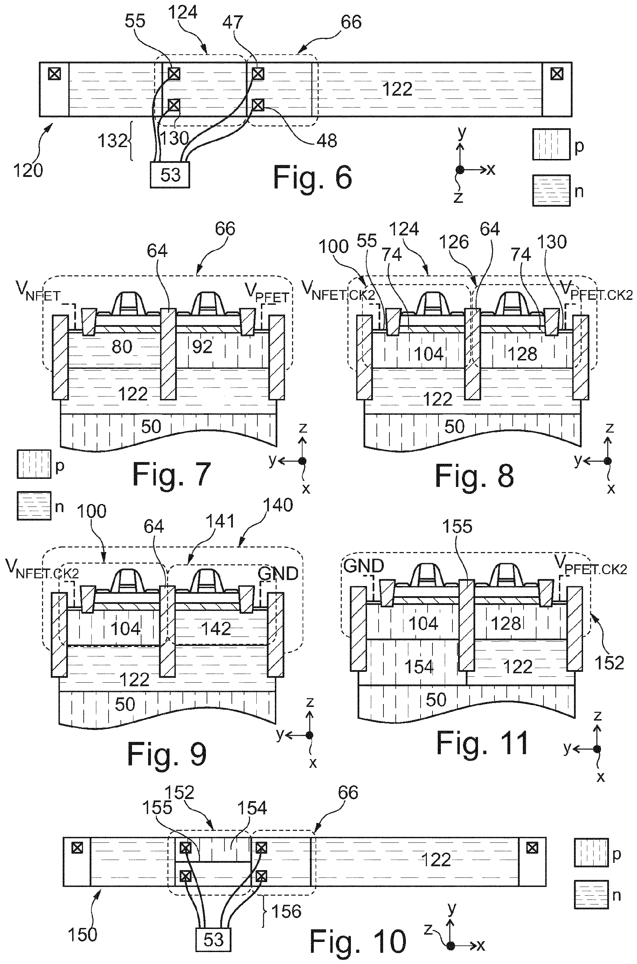

La figure 6 illustre une rangée 120 du bloc 6, pouvant être utilisée à la place de la rangée 52. Cette rangée 120 est identique à la rangée 52, sauf que :
- les caissons 60 et 62 sont remplacés par un unique caisson 122 ;
- la cellule 30 est remplacée par une cellule 124 d'arbre d'horloge ;
- la prise de polarisation 57, est remplacée par une prise identique, qui porte la référence 130.

Dans cet exemple, les caissons respectifs de chacune des autres rangées du bloc 6 sont également remplacés par un unique caisson propre à chacune de ces rangées. Le type de dopage des caissons contigus présente une alternance dans la direction Y.

Le réseau 51 est remplacé par un réseau 132, relié électriquement aux prises 47, 48, 55 et 130.

Le caisson 122 présente avantageusement un dopage de type et de concentration identiques à l'un ou l'autre des caissons 60 ou 62. Ici, le caisson 122 est identique au caisson 60 et présente donc un dopage de type n.

La figure 7 représente plus en détail la cellule 66 placée dans cette rangée 120. Les plans de masse 80 et 92 de la cellule 66 sont tous deux en contact électrique direct avec ce caisson 122.

La figure 8 représente plus en détail la cellule 124. Cette cellule 124 est identique à la cellule 30, sauf que le transistor 102 est remplacé par un transistor 126. Le transistor 126 est identique au transistor 102, sauf que le plan de masse 106 est remplacé par un plan de masse 128 de dopage opposé.

Les plans de masse 104 et 128 présentent ainsi un même dopage, de type opposé au dopage du caisson 122.

Avec ce choix de dopages, les plans de masse 104 et 128 de la cellule 124 peuvent être polarisés de manière à isoler électriquement les transistors 100 et 126 des transistors 68 et 70 de la cellule 66 contiguë (Fig. 7). Le caisson unique 122 permet de placer, au sein de la rangée 120, des cellules standard contiguës les unes aux autres et présentant des tensions de seuil de type différents.

La figure 9 représente une cellule 140 apte à remplacer la cellule 124. Cette cellule 140 est identique à la cellule 124, sauf que le transistor 126 est remplacé par un transistor 141. Le transistor 141 est identique au transistor 126 sauf que le plan de masse 128 est remplacé par un plan de masse 142 de dopage opposé. Par exemple, ce plan de masse 142 est identique au plan de masse 106. Ainsi, les plans de masse 104 et 142 présentent des dopages de type opposés. Le dopage du plan de masse 142 est du même type que le dopage du caisson 122.

Avec ce choix de types de dopages, en jouant sur la polarisation du plan de masse 104, le transistor 100 peut être électriquement isolé de la cellule 66 (Fig. 7) contiguë dans la même rangée 120, mais le plan de masse 142 de la cellule 140 ne l'est pas. Ce plan de masse 142 est ici apte à être porté à un même potentiel électrique que le plan de masse 80 de la cellule 66 contiguë, par l'intermédiaire du caisson 122. La cellule 140 est dite partiellement isolée.

Le fonctionnement des cellules 124 et 140 est identique au fonctionnement de la cellule 30, sauf que l'étape 114 est remplacée par une étape 206, représentée en pointillés sur la figure 5. Lors de cette étape 206, la polarisation électrique V_{PFET_CK2} est appliquée sur les plans de masse 128 ou 142. La polarisation V_{NFET_CK2} est appliquée sur le plan de masse 104. Ces polarisations V_{PFET_CK2} et V_{NFET_CK2} sont ici supérieures ou égales à la polarisation appliquée sur le caisson 122 , pour polariser en inverse la jonction p-n formée entre le plan de masse 104 et le caisson 122. A cet effet, ces polarisations V_{PFET_CK2} et V_{NFET_CK2} sont ici supérieures ou égales à la masse GND.

La figure 10 représente une rangée 150 de cellules, apte à remplacer la rangée 52 ou 120. Cette rangée 150 contient des cellules standard et une cellule d'arbre d'horloge 152. Sur la figure 9, seule la cellule standard 66 a été représentée. Cette rangée 150 est identique à la rangée 120, sauf qu'une moitié du caisson 122, située uniquement sous la cellule 152, est remplacée par un caisson 154, de dopage opposé. Ce caisson 154 est, par exemple, identique au caisson 62, sauf qu'il s'étend uniquement sous la cellule 152. Sous la cellule 152, ces caissons 122 et 154 s'étendent parallèlement l'un par rapport à l'autre dans la direction X. Ces caissons 122 et 154 sont ici séparés par une tranchée d'isolation profonde 155, identique à la tranchée 64 sauf qu'elle ne s'étend que dans la cellule 152. Le réseau 132 est remplacé par un réseau 156, identique au réseau 132, sauf qu'il est relié électriquement aux prises 47, 48, et aux prises de la cellule 152.

La figure 11 représente plus en détail la cellule 152. Cette cellule 152 présente des transistors dont les plans de masse présentent un dopage de même type. Cette cellule 152 est, par exemple, identique à la cellule 124.

Le fonctionnement de la cellule 152 est identique au fonctionnement de la cellule 140, sauf que l'étape 206 est remplacée par une étape 208, représentée en traits pointillés sur la figure 5. Cette étape est identique à l'étape 206, sauf que la polarisation électrique V_{PFET_CK2} est appliquée sur le plan de masse 128 pour polariser en inverse la jonction p-n formée entre le plan de masse 128 et le caisson 122.

De nombreux autres modes de réalisation sont possibles.

Le circuit 2 illustré à la figure 1 peut être différent de l'exemple illustré, et peut notamment comporter un plus grand nombre d'éléments logiques et/ou synchrones. L'ensemble 20 peut comprendre plus d'une entrée IN et/ou plus d'une sortie OUT.

Les rangées du bloc 6 peuvent présenter une configuration différente. Par exemple, les rangées peuvent être disposées dans une configuration dite non retournée (« regular » en langue anglaise). A cet effet, les caissons peuvent être disposés de manière identique dans chacune des rangées du bloc 6.

Dans une autre variante, les cellules d'un bloc placées les unes à côté des autres ne forment pas des rangées parallèles. Dans ce cas, par exemple, la hauteur des cellules dans la direction Y n'est pas la même pour toutes les cellules d'un même bloc de cellules contiguës. Les caissons communs à plusieurs cellules contiguës ne sont alors pas nécessairement rectilignes et peuvent adopter une grande variété de formes. Un tel agencement des cellules se rencontre par exemple dans les circuits logiques. Toutefois, ce qui a été décrit précédemment dans le cas où les cellules sont alignées dans des rangées, s'applique également à ces cas où de telles rangées n'existent pas.

La cellule 30 peut présenter une autre fonction que celle de délai. La cellule 30 est, par exemple, adaptée pour amplifier le signal d'entrée d'horloge.

Le substrat 50 peut présenter un dopage de type n.

La source 53 peut être omise. Dans ce cas, le réseau 51 est électriquement relié à une source d'alimentation située hors du circuit 2.

En variante, la tranchée 64 des cellules 124 et/ou 152 est remplacée par une tranchée d'isolation courte, par exemple identique à la tranchée 91. Cette tranchée courte permet d'isoler la couche active 72 de chacun des transistors 100 et 126 mais n'isole pas électriquement l'un de l'autre les plans de masse 104 et 128. Dans ce cas, ces plans de masse 104 et 128 peuvent être polarisés à un même potentiel électrique à l'aide d'une seule prise de contact. L'une ou l'autre des prises 55 ou 130 peut alors être omise.

La cellule 66 peut comprendre plus de deux transistors 68 et 70.

En variante, les transistors des cellules standard peuvent présenter une tension de seuil de type intermédiaire (RVT). Pour ce faire, les plans de masse respectifs de ces transistors peuvent être remplacés par des plans de masse présentant un dopage de type opposé (dopages de type p sous des nMOS et de type n sous des pMOS). Par exemple, les types de dopage des plans de masse 80 et 92 de la cellule 66 sont permutés. Dans ce cas, les types de dopage des plans de masse 104 et 106 de la cellule 30, ainsi que des caissons 60 et 62 sont alors permutés. La polarisation V_{PFET} est alors choisie égale à une tension d'alimentation VDD du circuit 2 en polarisation nominale. Les polarisations V_{PFET_CK1} et V_{NFET_CK1} sont, dans ce cas, choisies, respectivement, inférieure ou égale à la tension VDD et supérieure ou égale à la masse GND.

En variante, la source 82 et le drain 84 ne sont pas formés sur la couche 72, mais sont formés à l'intérieur de cette couche 72, ou bien à l'intérieur et au-dessus de cette couche 72, par exemple par épitaxie.

La rangée 120, comprenant le caisson 122, peut être utilisée au sein du bloc 6 à la place de la rangée 38. Il en va de même pour la rangée 150.

Le caisson 122 peut présenter un dopage de type p. Dans ce cas, les plans de masse 104 et 128 des cellules 124 et 152 sont remplacés par des plans de masse présentant des dopages de type opposé. Les polarisations V_{PFET_CK2} et V_{NFET_CK2} sont, dans ce cas, choisies supérieures ou égales à la masse GND.

Les polarisations V_{NFET} et V_{PFET} peuvent être modulées par un potentiel électrique variable ΔV, par exemple pour appliquer des polarisations de type inverse ou directe (respectivement dites RBB et FBB, pour « reverse back-biasing » et « forward back-biasing » en langue anglaise). Il en va de même pour les polarisations V_{PFET_CK1} et V_{NFET_CK1}, et V_{PFET_CK2} et V_{NFET_CK2}.

## Revendications

1. Circuit intégré (2), comprenant :
- un substrat (50) semi-conducteur, s'étendant essentiellement dans un plan, dit plan du substrat ;
- un premier caisson (40, 60) semi-conducteur, s'étendant dans un plan, dit plan des caissons, parallèle au plan du substrat ;
- une pluralité de cellules standard (46, 66) placées les unes à côté des autres, chaque cellule standard comportant un premier transistor à effet de champ et de technologie FDSOI, le premier transistor (68) comprenant un premier plan de masse (80) semi-conducteur, situé immédiatement sur le premier caisson, de manière à être en contact électrique avec le premier caisson, le premier caisson étant ainsi commun à toutes les cellules standard placées les unes à côté des autres ;
**caractérisé en ce que** le circuit intégré comporte également :
- une cellule d'arbre d'horloge (30), contiguë à des cellules standard, la cellule d'arbre d'horloge comportant un second transistor (100) à effet de champ de technologie FDSOI, le second transistor comportant un second plan de masse (104) semi-conducteur situé immédiatement sur le premier caisson (60), de manière à former une jonction p-n avec ce premier caisson, ce second plan de masse présentant à cet effet un dopage de type opposé au dopage du premier caisson ;
- un réseau d'alimentation (51) électrique apte à appliquer des polarisations électriques distinctes directement sur les premier et second plans de masse.

2. Circuit selon la revendication 1, dans lequel le circuit comprend une source d'alimentation (53) électriquement reliée au réseau d'alimentation électrique et apte à appliquer des polarisations électriques distinctes sur les premier et second plans de masse.

3. Circuit selon l'une quelconque des revendications précédentes, dans lequel la cellule d'arbre d'horloge (30) comprend une tranchée d'isolation (45), en matériau électriquement isolant, entourant le second plan de masse dans un plan parallèle au plan du substrat.

4. Circuit selon l'une quelconque des revendications précédentes, dans lequel chaque cellule standard (66) et d'arbre d'horloge (30) comporte, pour chaque plan de masse de cette cellule, au moins une première prise (47, 55) adaptée à être directement en contact électrique avec ledit plan de masse, cette première prise étant apte à polariser électriquement ledit plan de masse par une polarisation électrique fournie par une source de tension extérieure.

5. Circuit selon l'une quelconque des revendications précédentes, dans lequel chaque plan de masse (104) de chaque transistor (100) de la cellule d'horloge (30) présente un dopage de type opposé au dopage du caisson (60) sur lequel ce transistor est situé.

6. Circuit selon la revendication 5, dans lequel :
- le circuit comporte un second caisson (62) semi-conducteur, contigu au premier caisson (60) et s'étendant parallèlement au premier caisson dans le plan des caissons, le second caisson présentant un dopage de type opposé au dopage du premier caisson ;
- chaque cellule standard (66) inclut un troisième transistor (70) à effet de champ de technologie FDSOI, ce troisième transistor comportant un troisième plan de masse (92), situé immédiatement sur le second caisson (62), de manière à être en contact électrique avec ce second caisson, le second caisson étant ainsi commun à toutes les cellules standard placées les unes à côté des autres sur le premier caisson, les premier (80) et troisième (92) plans de masse présentant un dopage de même type que, respectivement, le dopage des premier (60) et second (62) caissons ;
- la cellule d'arbre d'horloge (30) inclut un quatrième transistor (102) à effet de champ de technologie FDSOI, ce quatrième transistor comportant un quatrième plan de masse (106), situé immédiatement au-dessus du second caisson (62) de manière à former une jonction p-n avec ce second caisson, ce quatrième plan de masse présentant un dopage de type opposé au dopage du second caisson.

7. Circuit selon l'une quelconque des revendications 1 à 4 , dans lequel :
- le premier plan de masse (80) présente un dopage de même type que le dopage du premier caisson (122) ;
- chaque cellule standard (66) inclut un troisième transistor à effet de champ de technologie FDSOI, ce troisième transistor comportant un troisième plan de masse (92), situé immédiatement sur le premier caisson, de manière à être en contact électrique avec ce premier caisson (122), le troisième plan de masse présentant un dopage de type opposé au dopage du premier plan de masse, le premier caisson étant ainsi commun à tous les transistors des cellules standard placées les unes à côté des autres sur le même premier caisson ;
- la cellule d'arbre d'horloge (124) inclut un quatrième transistor (126) à effet de champ de technologie FDSOI, le quatrième transistor comportant un quatrième plan de masse (128), situé immédiatement au-dessus du premier caisson (122) de manière à former une jonction p-n avec ce premier caisson, ce quatrième plan de masse (128) présentant à cet effet un dopage de même type que les second (104) et troisième (92) plans de masse.

8. Circuit selon l'une quelconque des revendications 1 à 4, dans lequel :
- chaque cellule standard (66) inclut un troisième transistor à effet de champ de technologie FDSOI, ce troisième transistor comportant un troisième plan de masse (92), situé immédiatement au-dessus du premier caisson (122) de manière à être en contact électrique avec ce premier caisson, le premier caisson étant ainsi commun à tous les transistors des cellules standard placées les unes à côté des autres sur le même premier caisson, le troisième plan de masse (92) présentant un dopage de type opposé au dopage du premier plan de masse (80) ;
- la cellule d'arbre d'horloge (140) inclut un quatrième transistor (141) à effet de champ de technologie FDSOI, ce quatrième transistor comportant un quatrième plan de masse (142), situé immédiatement au-dessus du premier caisson (122) de manière à être en contact électrique avec ce premier caisson, et présentant un dopage de type opposé au dopage du second plan de masse (104).

9. Circuit selon l'une quelconque des revendications 1 à 4, dans lequel :
- le circuit comporte un second caisson (122), contigu au premier caisson et présentant un dopage de type opposé au dopage du premier caisson (154) ;
- la cellule standard (66) inclut un troisième transistor à effet de champ de technologie FDSOI, le troisième transistor comportant un troisième plan de masse, situé immédiatement au-dessus du second caisson de manière à être en contact électrique avec ce second caisson (122), et présentant un dopage de type opposé au dopage du premier plan de masse ;
- la cellule d'arbre d'horloge (152) inclut un quatrième transistor à effet de champ de technologie FDSOI, ce quatrième transistor comportant un quatrième plan de masse (128), situé immédiatement au-dessus du second caisson (122) de manière à être en contact électrique avec ce second caisson, et présentant un dopage de même type que le dopage du second plan de masse (104).

10. Circuit selon l'une quelconque des revendications 7 ou 9, dans lequel les second (104) et quatrième (128) plans de masse de la cellule d'arbre d'horloge sont électriquement en contact l'un avec l'autre, pour que ces second et quatrième plans de masse soient polarisables à un même potentiel électrique, par application d'une polarisation électrique sur un seul de ces second et quatrième plans de masse.

11. Circuit selon l'une quelconque des revendications précédentes, dans lequel le circuit comporte une pluralité de rangées (38, 52) de cellules disposées parallèlement les unes aux autres sur le substrat, chaque rangée incluant au moins un exemplaire du premier caisson et plusieurs des cellules standards (46, 66) placées les unes à côté des autres dans cette rangée, l'une de ces rangée, dite rangée médiane, comportant la cellule d'arbre d'horloge contiguë aux cellules standard.

12. Procédé d'utilisation d'un circuit intégré, comportant les étapes suivantes:
- la fourniture (110) d'un circuit intégré conforme à l'une quelconque des revendications précédentes ;
- l'application (112) d'une première polarisation électrique sur le premier plan de masse ;
- l'application (114) d'une seconde polarisation électrique sur le second plan de masse, la seconde polarisation étant choisie en fonction de la première polarisation électrique appliquée au même moment sur le premier plan de masse de manière à polariser en sens inverse la jonction p-n formée entre le second plan de masse et le premier caisson.

## Patentansprüche

1. Integrierter Schaltkreis (2), umfassend:
- ein Halbleitersubstrat (50), das sich im Wesentlichen in Ebene, Substratebene genannt, erstreckt;
- eine erste Halbleiterwanne (40, 60), die sich in einer zur Substratebene parallelen Ebene, Wannenebene genannt, erstreckt;
- eine Vielzahl von Standardzellen (46, 66), die nebeneinander platziert sind, wobei jede Standardzelle einen ersten Feldeffekttransistor in FDSOI-Technologie umfasst, wobei der erste Transistor (68) eine erste Halbleitermasseebene (80) umfasst, die sich unmittelbar auf der ersten Wanne befindet, so dass sie mit der ersten Wanne in elektrischem Kontakt steht, wobei die erste Wanne damit allen nebeneinander platzierten Standardzellen gemeinsam ist;
**dadurch gekennzeichnet, dass** der integrierte Schaltkreis auch Folgendes umfasst:
- eine Taktbaumzelle (30), die an Standardzellen angrenzt, wobei die Taktbaumzelle einen zweiten Feldeffekttransistor (100) in FDSOI-Technologie umfasst, wobei der zweite Transistor eine zweite Halbleitermasseebene (104) umfasst, die sich unmittelbar auf der ersten Wanne (60) befindet, so dass sie mit dieser ersten Wanne einen p-n-Übergang bildet, wobei diese zweite Masseebene dazu eine Dotierung des Typs aufweist, der der Dotierung der ersten Wanne entgegengesetzt ist;
- ein elektrisches Versorgungsnetz (51), das dazu beschaffen ist, unterschiedliche elektrische Polarisierungen direkt an die erste und zweite Masseebene anzulegen.

2. Schaltkreis nach Anspruch 1, wobei der Schaltkreis eine Versorgungsquelle (53) umfasst, die mit dem elektrischen Versorgungsnetz elektrisch verbunden und dazu beschaffen ist, unterschiedliche elektrische Polarisierungen an die erste und zweite Masseebene anzulegen.

3. Schaltkreis nach einem der vorhergehenden Ansprüche, wobei die Taktbaumzelle (30) einen Isolationsgraben (45) aus elektrisch isolierendem Material umfasst, der die zweite Masseebene in einer zur Substratebene parallelen Ebene umgibt.

4. Schaltkreis nach einem der vorhergehenden Ansprüche, wobei jede Standardzelle (66) und Taktbaumzelle (30) für jede Masseebene dieser Zelle mindestens einen ersten Anschluss (47, 55) umfasst, der dazu geeignet ist, mit der Masseebene direkt in elektrischem Kontakt zu stehen, wobei dieser erste Anschluss dazu beschaffen ist, die Masseebene durch eine elektrische Polarisation, die von einer externen Spannungsquelle geliefert wird, elektrisch zu polarisieren.

5. Schaltkreis nach einem der vorhergehenden Ansprüche, wobei jede Masseebene (104) jedes Transistors (100) der Taktbaumzelle (30) eine Dotierung des Typs aufweist, der der Dotierung der Wanne (60), auf der sich der Transistor befindet, entgegengesetzt ist.

6. Schaltkreis nach Anspruch 5, wobei:
- der Schaltkreis eine zweite Halbleiterwanne (62) umfasst, die an die erste Wanne (60) angrenzt und sich in der Wannenebene parallel zur ersten Wanne erstreckt, wobei die zweite Wanne eine Dotierung des Typs aufweist, der der Dotierung der ersten Wanne entgegengesetzt ist;
- jede Standardzelle (66) einen dritten Feldeffekttransistor (70) in FDSOI-Technologie aufweist, wobei dieser dritte Transistor eine dritte Masseebene (92) umfasst, die sich unmittelbar auf der zweiten Wanne (62) befindet, so dass sie mit dieser zweiten Wanne in elektrischem Kontakt steht, wobei die zweite Wanne damit allen auf der ersten Wanne nebeneinander platzierten Standardzellen gemeinsam ist, wobei die erste (80) und dritte (92) Masseebene eine Dotierung desselben Typs aufweisen wie die Dotierung der ersten (60) bzw. zweiten (62) Wanne;
- die Taktbaumzelle (30) einen vierten Feldeffekttransistor (102) in FDSOI-Technologie aufweist, wobei dieser vierte Transistor eine vierte Masseebene (106) umfasst, die sich unmittelbar über der zweiten Wanne (62) befindet, so dass sie mit dieser zweiten Wanne einen p-n-Übergang bildet, wobei diese vierte Masseebene eine Dotierung des Typs aufweist, der der Dotierung der zweiten Wanne entgegengesetzt ist.

7. Schaltkreis nach einem der vorhergehenden Ansprüche 1 bis 4, wobei:
- die erste Masseebene (80) eine Dotierung desselben Typs aufweist wie die Dotierung der ersten Wanne (122);
- jede Standardzelle (66) einen dritten Feldeffekttransistor in FDSOI-Technologie aufweist, wobei dieser dritte Transistor eine dritte Masseebene (92) umfasst, die sich unmittelbar auf der ersten Wanne befindet, so dass sie mit dieser ersten Wanne (122) in elektrischem Kontakt steht, wobei die dritte Masseebene eine Dotierung des Typs aufweist, der der Dotierung der ersten Masseebene entgegengesetzt ist, wobei die erste Masseebene damit allen auf derselben ersten Wanne nebeneinander platzierten Transistoren der Standardzellen gemeinsam ist;
- die Taktbaumzelle (124) einen vierten Feldeffekttransistor (126) in FDSOI-Technologie aufweist, wobei der vierte Transistor eine vierte Halbleitermasseebene (128) umfasst, die sich unmittelbar über der ersten Wanne (122) befindet, so dass sie mit dieser ersten Wanne einen p-n-Übergang bildet, wobei diese vierte Masseebene (128) dazu eine Dotierung desselben Typs aufweist wie die zweite (104) und dritte (92) Masseebene.

8. Schaltkreis nach einem der vorhergehenden Ansprüche 1 bis 4, wobei:
- jede Standardzelle (66) einen dritten Feldeffekttransistor in FDSOI-Technologie aufweist, wobei dieser dritte Transistor eine dritte Masseebene (92) umfasst, die sich unmittelbar über der ersten Wanne (122) befindet, so dass sie mit dieser ersten Wanne in elektrischem Kontakt steht, wobei die erste Wanne damit allen auf derselben ersten Wanne nebeneinander platzierten Standardzellen gemeinsam ist, wobei die dritte Masseebene (92) eine Dotierung des Typs aufweist, der der Dotierung der ersten Masseebene (80) entgegengesetzt ist;
- die Taktbaumzelle (140) einen vierten Feldeffekttransistor (141) in FDSOI-Technologie aufweist, wobei dieser vierte Transistor eine vierte Halbleitermasseebene (142) umfasst, die sich unmittelbar über der ersten Wanne (122) befindet, so dass sie mit dieser ersten Wanne in elektrischem Kontakt steht, und eine Dotierung des Typs aufweist, der der Dotierung der zweiten Masseebene (104) entgegengesetzt ist.

9. Schaltkreis nach einem der vorhergehenden Ansprüche 1 bis 4, wobei:
- der Schaltkreis eine zweite Wanne (122) umfasst, die an die erste Wanne angrenzt und eine Dotierung des Typs aufweist, der der Dotierung der ersten Wanne (154) entgegengesetzt ist;
- die Standardzelle (66) einen dritten Feldeffekttransistor in FDSOI-Technologie aufweist, wobei der dritte Transistor eine dritte Masseebene umfasst, die sich unmittelbar über der zweiten Wanne befindet, so dass sie mit dieser zweiten Wanne (122) in elektrischem Kontakt steht, und eine Dotierung des Typs aufweist, der der Dotierung der ersten Masseebene entgegengesetzt ist;
- die Taktbaumzelle (152) einen vierten Feldeffekttransistor in FDSOI-Technologie aufweist, wobei dieser vierte Transistor eine vierte Masseebene (128) umfasst, die sich unmittelbar über der zweiten Wanne (122) befindet, so dass sie mit dieser zweiten Wanne in elektrischem Kontakt steht, und eine Dotierung desselben Typs aufweist wie die Dotierung der zweiten Masseebene (104).

10. Schaltkreis nach einem der Ansprüche 7 oder 9, wobei die zweite (104) und die vierte (128) Masseebene der Taktbaumzelle miteinander elektrisch in Kontakt stehen, damit diese zweite und vierte Masseebene durch Anlegen einer elektrischen Polarisation an eine einzige dieser zweiten und vierten Masseebene mit demselben elektrischen Potenzial polarisierbar sind.

11. Schaltkreis nach einem der vorhergehenden Ansprüche, wobei der Schaltkreis eine Vielzahl von Reihen (38, 52) von Zellen umfasst, die auf dem Substrat parallel zueinander angeordnet sind, wobei jede Reihe mindestens ein Exemplar der ersten Wanne und mehrere der Standardzellen (46, 66) aufweist, die in dieser Reihe nebeneinander platziert sind, wobei eine dieser Reihen, mittlere Reihe genannt, die Taktbaumzelle umfasst, die an die Standardzellen angrenzt.

12. Verfahren zur Nutzung eines integrierten Schaltkreises, die folgenden Schritte umfassend:
- Bereitstellen (110) eines integrierten Schaltkreises, der einem der vorhergehenden Ansprüche entspricht;
- Anlegen (112) einer ersten elektrischen Polarisation an die erste Masseebene;
- Anlegen (114) einer zweiten elektrischen Polarisation an die zweite Masseebene, wobei die zweite Polarisation in Abhängigkeit von der ersten elektrischen Polarisation gewählt wird, die zum selben Zeitpunkt an die erste Masseebene angelegt wird, um damit den p-n-Übergang, der zwischen der ersten Masseebene und der ersten Wanne gebildet ist, in umgekehrter Richtung zu polarisieren.

## Claims

1. Integrated circuit (2), comprising:
- a semiconductor substrate (50), extending essentially in a plane, called the plane of the substrate;
- a first semiconductor well (40, 60), extending in a plane, called the plane of the wells, parallel to the plane of the substrate;
- a plurality of standard cells (46, 66) placed beside one another, each standard cell comprising a first field-effect transistor employing FDSOI technology, the first transistor (68) comprising a first semiconductor ground plane (80), located immediately on the first well, so as to be in electrical contact with the first well, the first well thus being common to all of the standard cells placed beside one another;
**characterized in that** the integrated circuit also comprises:
- a clock tree cell (30), contiguous with standard cells, the clock tree cell comprising a second field-effect transistor (100) employing FDSOI technology, the second transistor comprising a second semiconductor ground plane (104) located immediately on the first well (60), so as to form a p-n junction with this first well, this second ground plane exhibiting, for this purpose, doping of the type opposite the doping of the first well;
- an electrical power supply network (51) able to apply distinct electrical biases directly to the first and second ground planes.

2. Circuit according to Claim 1, in which the circuit comprises a power source (53) that is electrically connected to the electrical power supply network and able to apply distinct electrical biases to the first and second ground planes.

3. Circuit according to either of the preceding claims, in which the clock tree cell (30) comprises a trench isolation (45), made of electrically insulating material, surrounding the second ground plane in a plane parallel to the plane of the substrate.

4. Circuit according to any one of the preceding claims, in which each standard cell (66) and clock tree cell (30) comprises, for each ground plane of this cell, at least one first tap (47, 55) designed to be in direct electrical contact with said ground plane, this first tap being able to electrically bias said ground plane by means of an electrical bias provided by an external voltage source.

5. Circuit according to any one of the preceding claims, in which each ground plane (104) of each transistor (100) of the clock cell (30) exhibits doping of the type opposite the doping of the well (60) on which this transistor is located.

6. Circuit according to Claim 5, in which:
- the circuit comprises a second semiconductor well (62), contiguous with the first well (60) and extending parallel to the first well in the plane of the wells, the second well exhibiting doping of the type opposite the doping of the first well;
- each standard cell (66) includes a third field-effect transistor (70) employing FDSOI technology, this third transistor comprising a third ground plane (92), located immediately on the second well (62), so as to be in electrical contact with this second well, the second well thus being common to all of the standard cells placed beside one another on the first well, the first (80) and third (92) ground planes exhibiting doping of the same type as the doping of the first (60) and second (62) wells, respectively;
- the clock tree cell (30) includes a fourth field-effect transistor (102) employing FDSOI technology, this fourth transistor comprising a fourth ground plane (106), located immediately on top of the second well (62) so as to form a p-n junction with this second well, this fourth ground plane exhibiting doping of the type opposite the doping of the second well.

7. Circuit according to any one of Claims 1 to 4, in which:
- the first ground plane (80) exhibits doping of the same type as the doping of the first well (122);
- each standard cell (66) includes a third field-effect transistor employing FDSOI technology, this third transistor comprising a third ground plane (92), located immediately on the first well, so as to be in electrical contact with this first well (122), the third ground plane exhibiting doping of the type opposite the doping of the first ground plane, the first well thus being common to all of the transistors of the standard cells placed beside one another on the same first well;
- the clock tree cell (124) includes a fourth field-effect transistor (126) employing FDSOI technology, the fourth transistor comprising a fourth ground plane (128), located immediately on top of the first well (122) so as to form a p-n junction with this first well, this fourth ground plane (128) exhibiting, for this purpose, doping of the same type as the second (104) and third (92) ground planes.

8. Circuit according to any one of Claims 1 to 4, in which:
- each standard cell (66) includes a third field-effect transistor employing FDSOI technology, this third transistor comprising a third ground plane (92), located immediately on top of the first well (122) so as to be in electrical contact with this first well, the first well thus being common to all of the transistors of the standard cells placed beside one another on the same first well, the third ground plane (92) exhibiting doping of the type opposite the doping of the first ground plane (80);
- the clock tree cell (140) includes a fourth field-effect transistor (141) employing FDSOI technology, this fourth transistor comprising a fourth ground plane (142), located immediately on top of the first well (122) so as to be in electrical contact with this first well, and exhibiting doping of the type opposite the doping of the second ground plane (104).

9. Circuit according to any one of Claims 1 to 4, in which:
- the circuit comprises a second well (122), contiguous with the first well and exhibiting doping of the type opposite the doping of the first well (154);
- the standard cell (66) includes a third field-effect transistor employing FDSOI technology, the third transistor comprising a third ground plane, located immediately on top of the second well so as to be in electrical contact with this second well (122), and exhibiting doping of the type opposite the doping of the first ground plane;
- the clock tree cell (152) includes a fourth field-effect transistor employing FDSOI technology, this fourth transistor comprising a fourth ground plane (128), located immediately on top of the second well (122) so as to be in electrical contact with this second well, and exhibiting doping of the same type as the doping of the second ground plane (104).

10. Circuit according to either of Claims 7 and 9, in which the second (104) and fourth (128) ground planes of the clock tree cell are in electrical contact with one another, so that these second and fourth ground planes can be biased at one and the same electrical potential, by applying an electrical bias to just one of these second and fourth ground planes.

11. Circuit according to any one of the preceding claims, in which the circuit includes a plurality of rows (38, 52) of cells arranged parallel to one another on the substrate, each row including at least one instance of the first well and a plurality of the standard cells (46, 66) placed beside one another in this row, one of these rows, called the middle row, comprising the clock tree cell contiguous with the standard cells.

12. Method for using an integrated circuit, comprising the following steps:
- providing (110) an integrated circuit according to any one of the preceding claims;
- applying (112) a first electrical bias to the first ground plane;
- applying (114) a second electrical bias to the second ground plane, the second bias being chosen according to the first electrical bias applied at the same time to the first ground plane so as to reverse-bias the p-n junction formed between the second ground plane and the first well.
